# EUROPÄISCHE PATENTANMELDUNG

(11) **EP 3 723 223 A1**
(43) Veröffentlichungstag der Anmeldung: **14.10.2020**
(21) Anmeldenummer: 19167802.8
(22) Anmeldetag: 08.04.2019
(51) Int. Cl.: H02H 3/16, G01R 31/02, H02H 3/17, H02H 7/26

(54) **ORTEN EINES ERDSCHLUSSES IN EINEM GLEICHSTROMNETZ**

(71) Anmelder: Siemens Aktiengesellschaft, 80333 München (DE)
(72) Erfinder: Schierling, Hubert, 91052 Erlangen (DE); Weis, Benno, 91334 Hemhofen (DE)

(57) **Zusammenfassung**

Die Erfindung betrifft ein Verfahren zum Orten eines Erdschlusses in einem Gleichstromnetz (1), dem mehrere Lastzonen (3, 5) zuschaltbar sind, die jeweils eine mit einer ersten Hauptleitung (7, 9) des Gleichstromnetzes (1) verbindbare erste Lastzonenleitung (31, 32) und eine mit einer zweiten Hauptleitung (7, 9) des Gleichstromnetzes (1) verbindbare zweite Lastzonenleitung (31, 32) aufweisen. Im Falle, dass an der ersten Hauptleitung (7, 9) ein Erdschluss zu einem Erdpotential detektiert wird, wird die zweite Hauptleitung (7, 9) mit dem Erdpotential verbunden. Ferner wird ermittelt, ob sich nach dem Verbinden der zweiten Hauptleitung (7, 9) mit dem Erdpotential in einer Lastzone (3, 5) eine einem definierten Stromänderungsmerkmal entsprechende Stromänderung auftritt. Falls in einer Lastzone (3, 5) eine dem Stromänderungsmerkmal entsprechende Stromänderung auftritt, wird der Erdschluss dieser Lastzone (3, 5) zugeordnet.

## Beschreibung

Die Erfindung betrifft ein Verfahren zum Orten eines Erdschlusses in einem Gleichstromnetz, dem mehrere Lastzonen zuschaltbar sind.

Ein gegenüber einem Erdpotential isoliertes oder über eine hohe Impedanz geerdetes Gleichstromnetz kann bei einem Erdschluss eines Gleichspannungspotentials weiter betrieben werden. Der Erdschluss selbst kann während des Betriebs durch die Messung und Auswertung der Spannungen zwischen den Gleichspannungspotentialen des Gleichstromnetzes und einem Erdpotential leicht detektiert werden. Allerdings ist es schwierig, diejenige an dem Gleichstromnetz angeschlossene Lastzone zu identifizieren, in der der Erdschluss aufgetreten ist. Die Identifizierung derjenigen Lastzone, in der der Erdschluss aufgetreten ist, ist jedoch wichtig, um die fehlerhafte Lastzone abzuschalten und den Erdschluss zu beseitigen. Um die fehlerhafte Lastzone zu identifizieren, könnte beispielsweise an einer Verbindungsstelle jeder Lastzone mit dem Gleichstromnetz, beispielsweise am Eingang eines Schaltschranks, ein so genannter Common-Mode-Strom, das heißt ein Fehlerstrom, der die Summe der Ströme in den beiden Anschlussleitungen der Lastzone zu den Hauptleitungen des Gleichstromnetzes ist, gemessen werden. Wenn einer der Common-Mode-Ströme von Null verschieden ist, weist dies darauf hin, dass der Erdschluss in der zugehörigen Lastzone aufgetreten ist. Die Messungen der Common-Mode-Ströme könnten beispielsweise permanent oder manuell durch Wartungspersonal durchgeführt werden. Jedoch sind derartige Messungen in jedem Fall aufwändig.

Der Erfindung liegt die Aufgabe zugrunde, ein verbessertes Verfahren zum Orten eines Erdschlusses in einem Gleichstromnetz anzugeben, dem mehrere Lastzonen zuschaltbar sind.

Die Aufgabe wird erfindungsgemäß durch ein Verfahren mit den Merkmalen des Anspruchs 1 und ein Gleichstromnetz mit den Merkmalen des Anspruchs 11 gelöst.

Vorteilhafte Ausgestaltungen der Erfindung sind Gegenstand der Unteransprüche.

Das erfindungsgemäße Verfahren dient zum Orten eines Erdschlusses in einem Gleichstromnetz, dem mehrere Lastzonen zuschaltbar sind, die jeweils eine mit einer ersten Hauptleitung des Gleichstromnetzes verbindbare erste Lastzonenleitung und eine mit einer zweiten Hauptleitung des Gleichstromnetzes verbindbare zweite Lastzonenleitung aufweisen. Bei dem Verfahren wird ein Stromänderungsmerkmal definiert, das eine Stromänderung eines Stroms in einer Lastzone charakterisiert, die im Fall eines in der Lastzone vorliegenden Erdschlusses zu einem Erdpotential entsteht, wenn die zweite Hauptleitung mit dem Erdpotential verbunden wird. Im Falle, dass an der ersten Hauptleitung ein Erdschluss zu einem Erdpotential detektiert wird, wird die zweite Hauptleitung mit dem Erdpotential verbunden. Ferner wird ermittelt, ob nach dem Verbinden der zweiten Hauptleitung mit dem Erdpotential in einer Lastzone eine dem Stromänderungsmerkmal entsprechende Stromänderung auftritt, und falls in einer Lastzone eine dem Stromänderungsmerkmal entsprechende Stromänderung auftritt, wird der Erdschluss dieser Lastzone zugeordnet. Hier und im Folgenden wird stets angenommen, dass das Gleichstromnetz gegenüber einem Erdpotential isoliert oder über eine hohe Impedanz geerdet ist. Die Verbindung einer Lastzonenleitung mit einer Hauptleitung des Gleichstromnetzes kann direkt oder indirekt sein, wobei eine indirekte Verbindung beispielsweise vorliegen kann, wenn das Gleichstromnetz hierarchisch aufgebaut ist, mit einer obersten Hierarchieebene, die direkt mit den Hauptleitungen verbunden ist, und wenigstens einer weiteren Hierarchieebene, die über die über ihr liegende Hierarchieebene oder die über ihr liegenden Hierarchieebenen mit den Hauptleitungen verbunden ist. Die Verbindung der zweiten Hauptleitung mit dem Erdpotential kann direkt oder indirekt sein. Unter einer indirekten Verbindung der zweiten Hauptleitung mit dem Erdpotential wird beispielsweise eine Verbindung über ein Schutzorgan verstanden und/oder eine Verbindung einer zweiten Lastzonenleitung einer speziellen Lastzone, insbesondere einer das Gleichstromnetz mit Energie versorgenden Lastzone, mit dem Erdpotential.

Das erfindungsgemäße Verfahren nutzt aus, dass ein Erdschluss zu dem Erdpotential in einer Lastzone einen Kurzschluss bewirkt, wenn die zweite Hauptleitung mit dem Erdpotential verbunden wird. Der Strompfad des Kurzschlusses verläuft zwischen den beiden Hauptleitungen über den Erdschluss in der Lastzone und die Erdverbindung der zweiten Hauptleitung. Der Kurzschlussstrom bewirkt in der den Erdschluss aufweisenden Lastzone eine charakteristische Stromänderung eines Stroms, die die Polarität der ersten Hauptleitung und die Art des Erzeugens der Erdverbindung der zweiten Hauptleitung widerspiegelt und daher durch ein entsprechendes Stromänderungsmerkmal charakterisiert werden kann. Das Auftreten eines dem Stromänderungsmerkmal entsprechenden Stroms in einer Lastzone nach dem Verbinden der zweiten Hauptleitung mit dem Erdpotential kann daher genutzt werden, um einen Erdschluss in dieser Lastzone zu erkennen. Wenn die erste Hauptleitung beispielsweise auf einem höheren Potential als die zweite Hauptleitung liegt, fließt ein Zusatzstrom, der durch den Kurzschluss erzeugt wird und den Laststrom überlagert, von der ersten Hauptleitung in die Lastzone hinein, in der der Erdschluss vorliegt, während aus den anderen Lastzonen jeweils ein durch den Kurzschluss erzeugter Zusatzstrom zu der ersten Hauptleitung hin herausfließt. Wenn die erste Hauptleitung auf einem niedrigeren Potential als die zweite Hauptleitung liegt, fließt entsprechend ein Zusatzstrom, der durch den Kurzschluss erzeugt wird und den Betriebsstrom überlagert, aus der Lastzone, in der der Erdschluss vorliegt, heraus zu der ersten Hauptleitung, während in die anderen Lastzonen jeweils ein durch den Kurzschluss erzeugter Zusatzstrom von der ersten Hauptleitung in die Lastzone hinein fließt. Die Stärke und der zeitliche Verlauf des Zusatzstroms (z. B. sprungartig oder ein bestimmtes Muster aufweisend) ist ferner von der Erzeugung der Erdverbindung der zweiten Hauptleitung abhängig. Dies kann genutzt werden, um ein geeignetes Stromänderungsmerkmal zu definieren.

Dementsprechend sieht eine Ausgestaltung des Verfahrens vor, dass das Stromänderungsmerkmal eine Richtung des Änderungsanteils des Stroms umfasst, auf den sich das Stromänderungsmerkmal bezieht, wobei die Richtung des Änderungsanteils von der Polarität der Spannung abhängt, die an der ersten Hauptleitung anliegt. Unter dem Änderungsanteil des Stroms, auf den sich das Stromänderungsmerkmal bezieht, wird dabei der durch den Kurzschluss erzeugte Zusatzstrom verstanden, welcher als Differenz des Stroms nach dem Verbinden der zweiten Hauptleitung mit dem Erdpotential und des Stroms vor dem Verbinden der zweiten Hauptleitung mit dem Erdpotential definiert und ermittelt werden kann. Die vorgenannte Ausgestaltung des Verfahrens nutzt den oben bereits beschriebenen Richtungsunterschied zwischen der Richtung des Zusatzstroms in der Lastzone, in der der Erdschluss vorliegt, und den Richtungen der Zusatzströme in den anderen Lastzonen aus.

Eine weitere Ausgestaltung des Verfahrens sieht vor, dass das Stromänderungsmerkmal eine Stromstärke des Änderungsanteils des Stroms umfasst, auf den sich das Stromänderungsmerkmal bezieht. Beispielsweise definiert das Stromänderungsmerkmal einen Mindestwert der Stromstärke des Änderungsanteils des Stroms, auf den sich das Stromänderungsmerkmal bezieht, wobei der Mindestwert ein Verhältnis der Stromstärke des Änderungsanteils zu einer Stromstärke eines Erdungsstroms ist, der durch die Verbindung der zweiten Hauptleitung mit dem Erdpotential fließt, beispielsweise ein Verhältnis im Bereich von 30 % bis 100 %. Diese Ausgestaltung der Erfindung nutzt aus, dass die Stromstärke des Zusatzstroms in der Lastzone, in der der Erdschluss vorliegt, größer ist als die Stromstärken der Zusatzströme in den anderen Lastzonen.

Eine weitere Ausgestaltung des Verfahrens sieht vor, dass eine Verbindungssequenz zeitlich aufeinander folgender Verbindungspulse vorgegeben wird, die zweite Hauptleitung mit dem Erdpotential mehrfach entsprechend der Verbindungssequenz verbunden wird und das Stromänderungsmerkmal eine der Verbindungssequenz entsprechende Stromänderung definiert. Beispielsweise wird die Verbindungssequenz als eine so genannte Pseudorandom Binary Sequence (PRBS) vorgegeben. Bei dieser Ausgestaltung des Verfahrens reicht zum Orten des Erdschlusses die Erzeugung kleiner Zusatzströme aus, weil die Zusatzströme in den Lastzonen durch deren Korrelationen mit der Verbindungssequenz erkannt und analysiert werden können. Die Auswertung der Ströme kann ferner vorteilhaft im laufenden Betrieb der Lastzonen mit überlagerten Lastströmen durchgeführt werden.

Bei einer weiteren Ausgestaltung des Verfahrens ist der Strom einer Lastzone, auf den sich das Stromänderungsmerkmal bezieht, ein in der ersten Lastzonenleitung der Lastzone fließender Leitungsstrom. Dadurch wird das Stromänderungsmerkmal auf denjenigen Leitungsstrom einer Lastzone bezogen, der in der Lastzonenleitung fließt, die mit der Hauptleitung verbunden ist, an der der Erdschluss detektiert wird.

Alternativ ist der Strom einer Lastzone, auf den sich das Stromänderungsmerkmal bezieht, ein Summenstrom, der eine Summe der in den beiden Lastzonenleitungen der Lastzone fließenden Leitungsströme ist. Im Unterschied zum Erkennen eines Erdschlusses in einer Lastzone durch Messung und Auswertung eines Common-Mode-Stroms am Eingang der Lastzone ohne das erfindungsgemäße Verbinden der zweiten Hauptleitung mit dem Erdpotential braucht dabei die Genauigkeit der Stromerfassung des Summenstroms nicht hoch zu sein, weil der Summenstrom in der Lastzone, in der der Erdschluss vorliegt, sehr hoch ist. Ferner leisten die in den beiden Lastzonenleitungen einer Lastzone fließenden Lastströme keinen oder nur einen sehr geringen Beitrag zu dem Summenstrom, so dass der Summenstrom direkt den Zusatzstrom abbildet.

Eine weitere Ausgestaltung der Erfindung sieht vor, dass das Stromänderungsmerkmal das Auslösen einer Überstromschutzeinrichtung in einer Lastzone nach dem Verbinden der zweiten Hauptleitung mit dem Erdpotential umfasst. Bei dieser Ausgestaltung des Verfahrens wird, wenn nach dem Verbinden der zweiten Hauptleitung mit dem Erdpotential in einer Lastzone eine Überstromschutzeinrichtung ausgelöst wird, der Erdschluss dieser Lastzone zugeordnet. Beispielsweise wird ein über die Verbindung der zweiten Hauptleitung mit dem Erdpotential fließender Erdungsstrom schrittweise erhöht bis in einer Lastzone eine Überstromschutzeinrichtung ausgelöst wird. Alternativ wird die zweite Hauptleitung derart mit dem Erdpotential verbunden, dass, wenn in einer Lastzone ein Erdschluss vorliegt, ein Strom in der Lastzone erzeugt wird, der größer ist als ein Auslösestrom jeder Lastzone, bei dem eine Überstromschutzeinrichtung der Lastzone ausgelöst wird, wobei die zweite Hauptleitung mit dem Erdpotential jedoch nur so kurzzeitig verbunden wird, dass in einer Lastzone nur beim Vorliegen eines Erdschlusses in dieser Lastzone die Überstromschutzeinrichtung ausgelöst wird.

Bei den vorgenannten Ausgestaltungen der Erfindung wird also die Lastzone, in der der Erdschluss vorliegt, durch das Auslösen einer Überstromschutzeinrichtung in der Lastzone erkannt. Im Fall, dass die zweite Hauptleitung mit dem Erdpotential nur so kurzzeitig verbunden wird, dass in einer Lastzone nur beim Vorliegen eines Erdschlusses in dieser Lastzone eine Überstromschutzeinrichtung ausgelöst wird, wird vorausgesetzt und ausgenutzt, dass jede Lastzone eine Überstromschutzeinrichtung aufweist, die ein von der Stromrichtung eines sie jeweils durchfließenden Stroms abhängiges Auslöseverhalten aufweist, so dass sie bei einem Überstrom einer ersten Stromrichtung eher auslöst als bei einem Überstrom in der der ersten Stromrichtung entgegengesetzten Stromrichtung. Da sich, wie oben bereits ausgeführt wurde, die Richtung des Zusatzstroms in der Lastzone, in der der Erdschluss vorliegt, von den Richtungen der Zusatzströme in den anderen Lastzonen unterschiedet, kann zumindest für einen Erdschluss, der an einer Hauptleitung mit einer bestimmten Polarität detektiert wird, durch eine Begrenzung der Dauer des Kurzschlusses erreicht werden, dass eine Überstromschutzeinrichtung in der Lastzone, in der der Erdschluss vorliegt, eher auslöst als in den anderen Lastzonen, wodurch der Kurzschluss beendet wird und keine Überstromschutzeinrichtung in einer weiteren Lastzone ausgelöst wird.

Ein erfindungsgemäßes Gleichstromnetz umfasst
- zwei Hauptleitungen,
- mehrere Lastzonen, die jeweils eine erste Lastzonenleitung, die mit einer ersten Hauptleitung des Gleichstromnetzes verbindbar ist, und eine zweite Lastzonenleitung, die mit der zweiten Hauptleitung des Gleichstromnetzes verbindbar ist, aufweisen,
- eine Erdschlussüberwachungseinheit, die dazu eingerichtet ist, Erdschlüsse an den Hauptleitungen zu detektieren,
- und eine Schaltereinheit, durch die die zweite Hauptleitung mit einem Erdpotential verbindbar ist.

Eine Ausgestaltung des Gleichstromnetzes sieht für jede Lastzone eine Messeinheit vor, die dazu eingerichtet ist, fortlaufend den in der ersten Lastzonenleitung der Lastzone fließenden Leitungsstrom oder einen Summenstrom, der eine Summe der in den beiden Lastzonenleitungen der Lastzone fließenden Leitungsströme ist, zu messen. Ferner sieht diese Ausgestaltung des Gleichstromnetzes eine Auswerteeinheit vor, die dazu eingerichtet ist, zu ermitteln, ob sich im Falle, dass an der ersten Hauptleitung ein Erdschluss zu dem Erdpotential detektiert wird, nach dem Verbinden der zweiten Hauptleitung mit dem Erdpotential in einer Lastzone eine einem definierten Stromänderungsmerkmal entsprechende Stromänderung des von der Messeinheit gemessenen Stroms auftritt, und falls in einer Lastzone eine dem Stromänderungsmerkmal entsprechende Stromänderung auftritt, den Erdschluss dieser Lastzone zuzuordnen.

Bei einer weiteren Ausgestaltung des Gleichstromnetzes ist die Verbindung der zweiten Hauptleitung mit dem Erdpotential derart gestaltet, dass ein über diese Verbindung fließender Erdungsstrom veränderbar ist. Beispielsweise ist der über die Verbindung der zweiten Hauptleitung mit dem Erdpotential fließende Erdungsstrom durch eine Steuereinheit steuerbar und die Steuereinheit ist dazu eingerichtet, den Erdungsstrom nach dem Verbinden der zweiten Hauptleitung mit dem Erdpotential schrittweise zu erhöhen bis in einer Lastzone eine Überstromschutzeinrichtung ausgelöst wird.

Die Schaltereinheit kann beispielsweise einen ansteuerbaren Halbleiterschalter aufweisen, insbesondere einen Halbleiterschalter, der durch die Steuereinheit ansteuerbar ist.

Ein erfindungsgemäßes Gleichstromnetz ermöglicht die Durchführung des erfindungsgemäßen Verfahrens mit den oben bereits genannten Vorteilen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 ein Blockschaltbild eines Gleichstromnetzes, dem mehrere Lastzonen zuschaltbar sind,
FIG 2 ein Blockschaltbild einer Lastzone und einer Zuschalteinheit, mit der dem Gleichstromnetz die Lastzone zuschaltbar ist.

Einander entsprechende Teile sind in den Figuren mit denselben Bezugszeichen versehen.

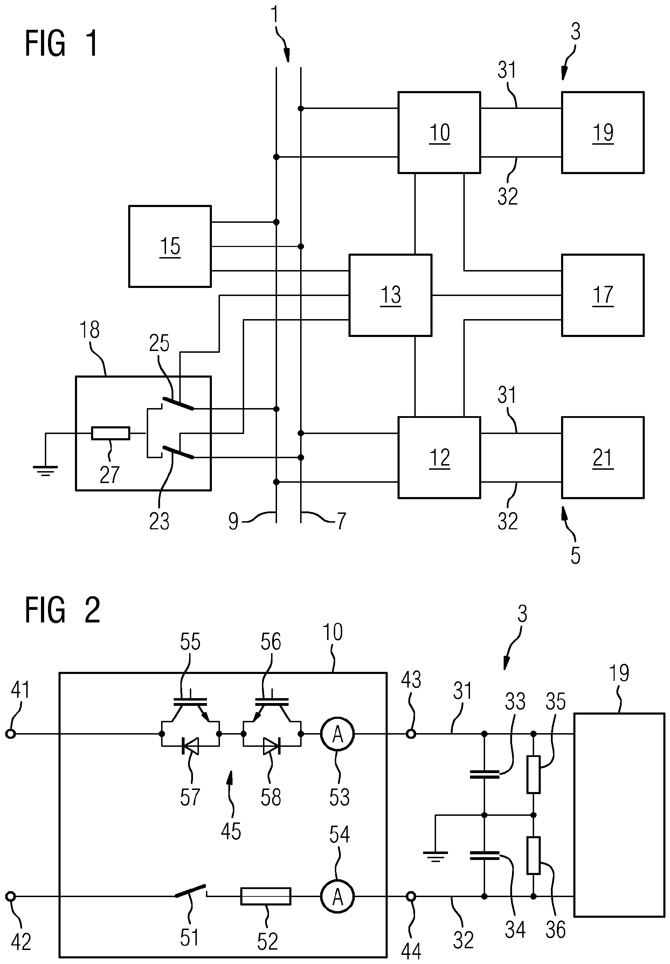

Figur 1 zeigt schematisch ein Ausführungsbeispiel eines Gleichstromnetzes 1, dem mehrere Lastzonen 3, 5 zuschaltbar sind. Das Gleichstromnetz 1 ist gegenüber einem Erdpotential isoliert oder über eine hohe Impedanz geerdet.

Das Gleichstromnetz 1 weist zwei elektrische Hauptleitungen 7, 9, für jede Lastzone 3, 5 eine Zuschalteinheit 10, 12 sowie eine Steuereinheit 13, eine Erdschlussüberwachungseinheit 15, eine Auswerteeinheit 17 und eine Schaltereinheit 18 auf.

In Figur 1 sind beispielhaft zwei Lastzonen 3, 5 dargestellt. Jede Lastzone 3, 5 weist eine elektrische Last 19, 21, beispielsweise eine elektrische Maschine und einen der elektrischen Maschine netzseitig vorgeschalteten Stromrichter, auf.

Die Hauptleitungen 7, 9 liegen auf voneinander verschiedenen Gleichspannungspotentialen des Gleichstromnetzes 1.

Jede Zuschalteinheit 10, 12 ist einer Lastzone 3, 5 zugeordnet, die dem Gleichstromnetz 1 durch die Zuschaltschalteinheit 10, 12 zuschaltbar ist.

Die Steuereinheit 13 ist mit den Zuschalteinheiten 10, 12, der Erdschlussüberwachungseinheit 15, der Auswerteeinheit 17 und der Schaltereinheit 18 verbunden. Von der Steuereinheit 13 wird insbesondere das Zuschalten der Lastzonen 3, 5 gesteuert.

Die Erdschlussüberwachungseinheit 15 ist dazu eingerichtet, an den Hauptleitungen 7, 9 Erdschlüsse zu dem Erdpotential zu detektieren. Dazu ist die Erdschlussüberwachungseinheit 15 mit jeder Hauptleitung 7, 9 verbunden und dazu eingerichtet, die Spannungen zwischen dem Erdpotential und den Gleichspannungspotentialen, auf denen die Hauptleitungen 7, 9 liegen, zu messen. Ferner ist die Erdschlussüberwachungseinheit 15 dazu eingerichtet, der Steuereinheit 13 einen detektierten Erdschluss zu melden.

Die Auswerteeinheit 17 ist mit der Steuereinheit 13 und den Zuschalteinheiten 10, 12 verbunden und dazu eingerichtet, in unten näher beschriebener Weise Ströme in den Lastzonen 3, 5 auszuwerten.

Die Schaltereinheit 18 weist für jede Hauptleitung 7, 9 einen Schalter 23, 25 auf, durch den die Hauptleitung 7, 9 über eine Verbindungsimpedanz 27, insbesondere einen Verbindungswiderstand, mit dem Erdpotential verbindbar ist. Die Schalter 23, 25 sind beispielsweise jeweils als ein von der Steuereinheit 13 ansteuerbarer abschaltbarer Halbleiterschalter, beispielsweise als ein Bipolartransistor mit isolierter Gate-Elektrode (IGBT), oder Thyristor ausgebildet. Alternativ können die Schalter 23, 25 jeweils als ein mechanischer Schalter ausgebildet sein.

Figur 2 zeigt beispielhaft ein Blockschaltbild einer Lastzone 3 und der Zuschalteinheit 10, mit der die Lastzone 3 dem Gleichstromnetz 1 zuschaltbar ist.

Die Lastzone 3 weist zwei symmetrisch geerdete Lastzonenleitungen 31, 32 auf, wobei die Lastzonenleitungen 31, 32 über jeweils eine Parallelschaltung eines Erdungskondensators 33, 34 und eines Erdungswiderstands 35, 36 gleichartig, das heißt mit Erdungskondensatoren 33, 34 gleicher Kapazitäten und Erdungswiderständen 35, 36 gleicher Widerstandswerte, hochimpedant ohmsch-kapazitiv geerdet sind, um Lastzonenpotentiale, auf denen die Lastzonenleitungen 31, 32 liegen, im fehlerfreien Betrieb symmetrisch zu dem Erdpotential zu halten.

Die Zuschalteinheit 10 weist zwei netzseitige Anschlüsse 41, 42, zwei lastzonenseitige Anschlüsse 43, 44, zwei Schalter 45, 51, eine Sicherung 52 und zwei Messeinheiten 53, 54 auf.

Der netzseitige Anschluss 41 ist mit der Hauptleitung 7 verbunden. Der netzseitige Anschluss 42 ist mit der Hauptleitung 9 verbunden. Der lastzonenseitige Anschluss 43 ist mit der Lastzonenleitung 31 verbunden. Der lastzonenseitige Anschluss 44 ist mit der Lastzonenleitung 32 verbunden.

Der Schalter 45 und die Messeinheit 53 sind in Reihe zwischen den netzseitigen Anschluss 41 und den lastzonenseitigen Anschluss 43 geschaltet. Der Schalter 45 ist ein elektronischer Schalter, der zwei abschaltbare Halbleiterschalter 55, 56 und zwei Dioden 57, 58 aufweist. Die Halbleiterschalter 55, 56 sind antiseriell geschaltet, das heißt die Halbleiterschalter 55, 56 sind in Reihe, aber mit einander entgegensetzten Durchlassrichtungen geschaltet. Jede Diode 57, 58 ist antiparallel zu einem der Halbleiterschalter 55, 56 geschaltet. Der Schalter 45 ist als ein schneller Schalter ausgebildet, der Kurzschlussströme abschalten kann, und von der Steuereinheit 13 ansteuerbar. Die Messeinheit 53 ist dazu eingerichtet, fortlaufend einen in der Lastzonenleitung 31 fließenden Leitungsstrom zu messen.

Der Schalter 51, die Sicherung 52 und die Messeinheit 54 sind in Reihe zwischen den netzseitigen Anschluss 42 und den lastzonenseitigen Anschluss 44 geschaltet. Der Schalter 51 ist beispielsweise ein mechanischer Lasttrennschalter. Alternativ kann auch der Schalter 51 als ein elektronischer Schalter wie der Schalter 45 ausgebildet sein. Die Messeinheit 54 ist dazu eingerichtet, fortlaufend einen in der Lastzonenleitung 32 fließenden Leitungsstrom zu messen.

Die Messeinheiten 53, 54 übertragen die von ihnen erfassten Messsignale an die Auswerteeinheit 17.

Erfindungsgemäß wird im Falle, dass an einer der Hauptleitungen 7, 9, die im Folgenden als erste Hauptleitung 7, 9 bezeichnet wird, ein Erdschluss zu dem Erdpotential detektiert wird, die andere Hauptleitung 7, 9, die im Folgenden als zweite Hauptleitung 7, 9 bezeichnet wird, mit dem Erdpotential verbunden, indem der mit der zweiten Hauptleitung 7, 9 verbundene Schalter 23, 25 geschlossen wird. Anschließend wird ermittelt, ob nach dem Verbinden der zweiten Hauptleitung 7, 9 mit dem Erdpotential in einer Lastzone 3, 5 eine Stromänderung auftritt, die einem definierten Stromänderungsmerkmal entspricht. Falls eine solche Stromänderung ermittelt wird, wird der Erdschluss derjenigen Lastzone 3, 5 zugeordnet, in der diese Stromänderung auftritt.

Im Folgenden werden die mit der ersten Hauptleitung 7, 9 verbundenen Lastzonenleitungen 31, 32 als erste Lastzonenleitungen 31, 32 und die mit der zweiten Hauptleitung 7, 9 verbundenen Lastzonenleitungen 31, 32 als zweite Lastzonenleitungen 31, 32 bezeichnet.

Das Stromänderungsmerkmal charakterisiert eine Stromänderung eines Stroms in einer Lastzone 3, 5, die im Fall eines in der Lastzone 3, 5 vorliegenden Erdschlusses zu dem Erdpotential entsteht, wenn die zweite Hauptleitung 7, 9 mit dem Erdpotential verbunden wird.

Beispielsweise umfasst das Stromänderungsmerkmal eine Richtung des Änderungsanteils des Stroms, auf den sich das Stromänderungsmerkmal bezieht, wobei die Richtung des Änderungsanteils von der Polarität der Spannung abhängt, die an der ersten Hauptleitung 7, 9 anliegt.

Alternativ oder zusätzlich umfasst das Stromänderungsmerkmal eine Stromstärke des Änderungsanteils des Stroms, auf den sich das Stromänderungsmerkmal bezieht. Beispielsweise definiert das Stromänderungsmerkmal einen Mindestwert dieser Stromstärke, wobei der Mindestwert ein Verhältnis der Stromstärke des Änderungsanteils zu einer Stromstärke eines Erdungsstroms ist, der durch die Verbindung der zweiten Hauptleitung 7, 9 mit dem Erdpotential fließt.

Ferner kann vorgesehen sein, dass eine Verbindungssequenz zeitlich aufeinander folgender Verbindungspulse vorgegeben und die zweite Hauptleitung 7, 9 mit dem Erdpotential mehrfach entsprechend der Verbindungssequenz verbunden wird. In diesem Fall definiert das Stromänderungsmerkmal eine der Verbindungssequenz entsprechende Stromänderung.

Beispielsweise ist der Strom einer Lastzone 3, 5, auf den sich das Stromänderungsmerkmal bezieht, der Leitungsstrom in der ersten Lastzonenleitung 31, 32 der Lastzone 3, 5. Die zweite Hauptleitung 7, 9 wird beispielsweise derart mit dem Erdpotential verbunden, dass, auch wenn in einer Lastzone 3, 5 ein Erdschluss vorliegt, in keiner Lastzone 3, 5 ein Strom erzeugt wird, der größer ist als ein Auslösestrom, bei dem eine Überstromschutzeinrichtung (beispielsweise der Schalter 45 oder die Sicherung 52) der Lastzone 3, 5 ausgelöst wird. Die Strombegrenzung wird beispielsweise durch eine geeignete Verbindungsimpedanz 27 erreicht. Im Fall, dass der mit der zweiten Hauptleitung 7, 9 verbundene Schalter 23, 25 ein abschaltbarer Halbleiterschalter ist, kann alternativ der Schalter 23, 25 allein oder in Verbindung mit der Verbindungsimpedanz 27 die Strombegrenzung bewirken, beispielsweise durch Ausnutzen eines Sättigungsverhaltens des Schalters 23, 25, Verschalten des Schalters 23, 25 als Stromquelle (nicht dargestellt), Abschalten des Schalters 23, 25 bei Überschreiten einer Stromgrenze oder Begrenzen der Einschaltdauer des Schalters 23, 25, beispielsweise auf höchstens 50 µs.

Bei einer derartigen Strombegrenzung werden die nach dem Verbinden der zweiten Hauptleitung 7, 9 mit dem Erdpotential erfassten Leitungsströme in den ersten Lastzonenleitungen 31, 32 von der Auswerteeinheit 17 ausgewertet, um den Erdschluss einer Lastzone 3, 5 zuzuordnen.

Alternativ wird die zweite Hauptleitung 7, 9 beispielsweise derart mit dem Erdpotential verbunden, dass, wenn in einer Lastzone 3, 5 ein Erdschluss vorliegt, ein Strom in der Lastzone 3, 5 erzeugt wird, der größer ist als ein Auslösestrom wenigstens einer oder jeder Lastzone 3, 5, bei dem eine Überstromschutzeinrichtung der Lastzone 3, 5 ausgelöst wird, wobei die zweite Hauptleitung 7, 9 mit dem Erdpotential jedoch vorzugsweise nur so kurzzeitig verbunden wird, dass in einer Lastzone 3, 5 nur beim Vorliegen eines Erdschlusses in dieser Lastzone 3, 5 die Überstromschutzeinrichtung ausgelöst wird. Wenn dann in einer Lastzone 3, 5 nach dem Verbinden der zweiten Hauptleitung 7, 9 mit dem Erdpotential in einer Lastzone 3, 5 die Überstromschutzeinrichtung ausgelöst wird, wird der Erdschluss dieser Lastzone 3, 5 zugeordnet.

Ferner kann vorgesehen sein, dass der Kurzschlussstrom schrittweise erhöht wird bis in einer Lastzone 3, 5 eine Überstromschutzeinrichtung ausgelöst wird, und dass der Erdschluss derjenigen Lastzone 3, 5 zugeordnet wird, in der die Überstromschutzeinrichtung ausgelöst wird.

Wenn ein Erdschluss einer Lastzone 3, 5 zugeordnet wird, wird diese Lastzone 3, 5 vorzugsweise von dem Gleichstromnetz 1 getrennt, um den Erdschluss zu beheben. Dazu übermittelt beispielsweise die Auswerteeinheit 17 das Ergebnis der Auswertung der Leitungsströme an die Steuereinheit 13 und die die Steuereinheit 13 trennt diese Lastzone 3, 5 von dem Gleichstromnetz 1.

Die anhand der Figuren beschriebenen Ausführungsbeispiele des erfindungsgemäßen Verfahrens und eines erfindungsgemäßen Gleichstromnetzes 1 können auf verschiedene Weisen zu weiteren Ausführungsbeispielen abgewandelt werden. Beispielsweise kann die Schaltereinheit 18 statt eines Schalters 23, 25 für jede Hauptleitung 7, 9 einen Schalter aufweisen, mit dem wahlweise eine der beiden Hauptleitungen 7, 9 mit dem Erdpotential verbindbar ist. Die Schaltereinheit 18 braucht ferner nicht direkt mit den Hauptleitungen 7, 9 verbunden sein, sondern kann stattdessen indirekt mit den Hauptleitungen 7, 9 verbunden sein, beispielsweise über ein Schutzorgan. Die Schaltereinheit 18 kann beispielsweise auch innerhalb einer (nicht dargestellten) speziellen Lastzone angeordnet sein, insbesondere innerhalb einer Lastzone, die das Gleichstromnetz 1 mit Energie versorgt. Ferner kann die Auswerteeinheit 17 in die Steuereinheit 13 oder in die Erdschlussüberwachungseinheit 15 integriert sein. Alternativ kann statt einer übergeordneten Auswerteeinheit 17 für jede Zuschalteinheit 10, 12 eine lokale Auswerteeinheit 17 vorgesehen sein, die den Leitungsstrom der ersten Lastzonenleitung 31, 32 der Lastzone 3, 5 auswertet. Zusätzlich kann vorgesehen sein, dass eine Lastzone 3, 5, die sich selbst einen Erdschluss zuordnet, sich selbst abschaltet und/oder den Erdschluss (beispielsweise optisch) signalisiert und/oder an eine zentrale Überwachung (beispielsweise an die Steuereinheit 13) meldet.

Ferner kann der Strom einer Lastzone 3, 5, auf den sich das Stromänderungsmerkmal bezieht, ein Summenstrom sein, der eine Summe der in den beiden Lastzonenleitungen 31, 32 der Lastzone 3, 5 fließenden Leitungsströme ist. In diesem Fall werden die Summenströme der Lastzonen 3, 5 erfasst und nach dem Verbinden der zweiten Hauptleitung 7, 9 mit dem Erdpotential ausgewertet, um den Erdschluss zu orten, statt die in den ersten Lastzonenleitungen 31, 32 der Lastzonen 3, 5 fließenden Leitungsströme zu erfassen und auszuwerten.

Das erfindungsgemäße Verfahren ist ferner auch für ein Gleichstromnetz 1 anwendbar, in dem nur für eine der beiden Lastzonenleitungen 31, 32 jeder Lastzone 3, 5 eine Messeinheit 53, 54 vorhanden ist, während für die andere Lastzonenleitung 31, 32 nur eine Überstromschutzeinrichtung, beispielsweise eine Sicherung 52, vorhanden ist. Beispielsweise kann nur jeweils für die mit der Hauptleitung 7 verbundene Lastzonenleitung 31 jeder Lastzone 3, 5 eine Messeinheit 53 vorhanden sein. In diesem Fall wird beispielsweise, wenn an der Hauptleitung 7 ein Erdschluss detektiert wird, die Hauptleitung 9 mit dem Erdpotential derart verbunden, dass in keiner Lastzone 3, 5 eine Überstromschutzeinrichtung ausgelöst wird, und die Leitungsströme der Lastzonenleitungen 31 der Lastzonen 3, 5 werden nach dem Verbinden der Hauptleitung 9 mit dem Erdpotential in der oben beschriebenen Weise ausgewertet, um den Erdschluss zu orten. Wenn hingegen an der Hauptleitung 9 ein Erdschluss detektiert wird, wird die Hauptleitung 7 mit dem Erdpotential verbunden und es wird ein Auslösen der Überstromschutzeinrichtung in einer Lastzone 3, 5 erzeugt, um den Erdschluss zu orten, beispielsweise indem der Erdungsstrom schrittweise erhöht wird bis in einer Lastzone 3, 5 die Überstromschutzeinrichtung ausgelöst wird.

Das erfindungsgemäße Verfahren ist auch für ein Gleichstromnetz 1 anwendbar, in dem nur eine der beiden Hauptleitungen 7, 9 mit einer Lastzonenleitung 31, 32 jeder Lastzone 3, 5 verbunden ist, für die eine Messeinheit 53, 54 oder eine Überstromschutzeinrichtung vorhanden ist, während für die andere Lastzonenleitung 31, 32 jeder Lastzone 3, 5 weder eine Messeinheit 53, 54 noch eine Überstromschutzeinrichtung vorhanden ist. In diesem Fall können mit dem erfindungsgemäßen Verfahren jedoch nur Erdschlüsse geortet werden, die an derjenigen Hauptleitung 7, 9 detektiert werden, die mit Lastzonenleitungen 31, 32 verbindbar ist, in denen eine Messeinheit 53, 54 oder eine Überstromschutzeinrichtung vorhanden ist.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Orten eines Erdschlusses in einem Gleichstromnetz (1), dem mehrere Lastzonen (3, 5) zuschaltbar sind, die jeweils eine mit einer ersten Hauptleitung (7, 9) des Gleichstromnetzes (1) verbindbare erste Lastzonenleitung (31, 32) und eine mit einer zweiten Hauptleitung (7, 9) des Gleichstromnetzes (1) verbindbare zweite Lastzonenleitung (31, 32) aufweisen, wobei
- ein Stromänderungsmerkmal definiert wird, das eine Stromänderung eines Stroms in einer Lastzone (3, 5) charakterisiert, die im Fall eines in der Lastzone (3, 5) vorliegenden Erdschlusses zu einem Erdpotential entsteht, wenn die zweite Hauptleitung (7, 9) mit dem Erdpotential verbunden wird,
- im Falle, dass an der ersten Hauptleitung (7, 9) ein Erdschluss zu einem Erdpotential detektiert wird, die zweite Hauptleitung (7, 9) mit dem Erdpotential verbunden wird,
- ermittelt wird, ob nach dem Verbinden der zweiten Hauptleitung (7, 9) mit dem Erdpotential in einer Lastzone (3, 5) eine dem Stromänderungsmerkmal entsprechende Stromänderung auftritt,
- und falls in einer Lastzone (3, 5) eine dem Stromänderungsmerkmal entsprechende Stromänderung auftritt, der Erdschluss dieser Lastzone (3, 5) zugeordnet wird.

2. Verfahren nach Anspruch 1, wobei das Stromänderungsmerkmal eine Richtung des Änderungsanteils des Stroms umfasst, auf den sich das Stromänderungsmerkmal bezieht, wobei die Richtung des Änderungsanteils von der Polarität einer Spannung abhängt, die an der ersten Hauptleitung (7, 9) anliegt.

3. Verfahren nach Anspruch 1 oder 2, wobei das Stromänderungsmerkmal eine Stromstärke des Änderungsanteils des Stroms umfasst, auf den sich das Stromänderungsmerkmal bezieht.

4. Verfahren nach Anspruch 3, wobei das Stromänderungsmerkmal einen Mindestwert der Stromstärke des Änderungsanteils des Stroms definiert, auf den sich das Stromänderungsmerkmal bezieht, wobei der Mindestwert ein Verhältnis der Stromstärke des Änderungsanteils zu einer Stromstärke eines Erdungsstroms ist, der durch die Verbindung der zweiten Hauptleitung (7, 9) mit dem Erdpotential fließt.

5. Verfahren nach einem der vorhergehenden Ansprüche, wobei eine Verbindungssequenz zeitlich aufeinander folgender Verbindungspulse vorgegeben wird, die zweite Hauptleitung (7, 9) mit dem Erdpotential mehrfach entsprechend der Verbindungssequenz verbunden wird und das Stromänderungsmerkmal eine der Verbindungssequenz entsprechende Stromänderung definiert.

6. Verfahren nach einem der vorhergehenden Ansprüche, wobei der Strom einer Lastzone (3, 5), auf den sich das Stromänderungsmerkmal bezieht, ein in der ersten Lastzonenleitung (31, 32) der Lastzone (3, 5) fließender Leitungsstrom ist.

7. Verfahren nach einem der Ansprüche 1 bis 5, wobei der Strom einer Lastzone (3, 5), auf den sich das Stromänderungsmerkmal bezieht, ein Summenstrom ist, der eine Summe der in den beiden Lastzonenleitungen (31, 32) der Lastzone (3, 5) fließenden Leitungsströme ist.

8. Verfahren nach Anspruch 1, wobei das Stromänderungsmerkmal das Auslösen einer Überstromschutzeinrichtung in einer Lastzone (3, 5) nach dem Verbinden der zweiten Hauptleitung (7, 9) mit dem Erdpotential umfasst.

9. Verfahren nach Anspruch 8, wobei ein über die Verbindung der zweiten Hauptleitung (7, 9) mit dem Erdpotential fließender Erdungsstrom schrittweise erhöht wird bis in einer Lastzone (3, 5) eine Überstromschutzeinrichtung ausgelöst wird.

10. Verfahren nach Anspruch 8, wobei die zweite Hauptleitung (7, 9) derart mit dem Erdpotential verbunden wird, dass, wenn in einer Lastzone (3, 5) ein Erdschluss vorliegt, ein Strom in der Lastzone (3, 5) erzeugt wird, der größer ist als ein Auslösestrom jeder Lastzone (3, 5), bei dem eine Überstromschutzeinrichtung der Lastzone (3, 5) ausgelöst wird, und wobei die zweite Hauptleitung (7, 9) mit dem Erdpotential nur so kurzzeitig verbunden wird, dass in einer Lastzone (3, 5) nur beim Vorliegen eines Erdschlusses in dieser Lastzone (3, 5) die Überstromschutzeinrichtung ausgelöst wird.

11. Gleichstromnetz (1), umfassend
- zwei Hauptleitungen (7, 9),
- mehrere Lastzonen (3, 5), die jeweils eine erste Lastzonenleitung (31, 32), die mit einer ersten Hauptleitung (7, 9) des Gleichstromnetzes (1) verbindbar ist, und eine zweite Lastzonenleitung (31, 32), die mit der zweiten Hauptleitung (7, 9) des Gleichstromnetzes (1) verbindbar ist, aufweisen,
- eine Erdschlussüberwachungseinheit (15), die dazu eingerichtet ist, Erdschlüsse an den Hauptleitungen (7, 9) zu detektieren,
- und eine Schaltereinheit (18), durch die die zweite Hauptleitung (7, 9) mit einem Erdpotential verbindbar ist.

12. Gleichstromnetz (1) nach Anspruch 11, das für jede Lastzone (3, 5) eine Messeinheit (53, 54) aufweist, die dazu eingerichtet ist, fortlaufend den in der ersten Lastzonenleitung (31, 32) der Lastzone (3, 5) fließenden Leitungsstrom oder einen Summenstrom, der eine Summe der in den beiden Lastzonenleitungen (31, 32) der Lastzone (3, 5) fließenden Leitungsströme ist, zu messen, und das eine Auswerteeinheit (17) aufweist, die dazu eingerichtet ist, zu ermitteln, ob sich im Falle, dass an der ersten Hauptleitung (7, 9) ein Erdschluss zu dem Erdpotential detektiert wird, nach dem Verbinden der zweiten Hauptleitung (7, 9) mit dem Erdpotential in einer Lastzone (3, 5) eine einem definierten Stromänderungsmerkmal entsprechende Stromänderung des von der Messeinheit (53, 54) gemessenen Stroms auftritt, und falls in einer Lastzone (3, 5) eine dem Stromänderungsmerkmal entsprechende Stromänderung auftritt, den Erdschluss dieser Lastzone (3, 5) zuzuordnen.

13. Gleichstromnetz (1) nach Anspruch 11 oder 12, wobei die Verbindung der zweiten Hauptleitung (7, 9) mit dem Erdpotential derart gestaltet ist, dass ein über diese Verbindung fließender Erdungsstrom veränderbar ist.

14. Gleichstromnetz (1) nach Anspruch 13, wobei der über die Verbindung der zweiten Hauptleitung (7, 9) mit dem Erdpotential fließende Erdungsstrom durch eine Steuereinheit (13) steuerbar ist und die Steuereinheit (13) dazu eingerichtet ist, den Erdungsstrom nach dem Verbinden der zweiten Hauptleitung (7, 9) mit dem Erdpotential schrittweise zu erhöhen bis in einer Lastzone (3, 5) eine Überstromschutzeinrichtung ausgelöst wird.

15. Gleichstromnetz (1) nach einem der Ansprüche 11 bis 14, wobei die Schaltereinheit (18) einen ansteuerbaren Halbleiterschalter aufweist.
